# EUROPEAN PATENT APPLICATION

(11) **EP 4 769 836 A2**
(43) Date of publication of application: **01.07.2026**
(21) Application number: 26177956.5
(22) Date of filing: 01.03.2023
(51) Int. Cl.: H01Q 5/314

(54) **BICONICAL ANTENNA ASSEMBLY AND TEST SYSTEM**

(62) Divisional of application: 23159438.3
(71) Applicant: Rohde & Schwarz GmbH & Co. KG, 81671 München (DE)
(72) Inventor: Goeritz, Raimon, 81671 München (DE)
(74) Representative: Prinz & Partner mbB

(57) **Abstract**

The invention relates to a test system (54) for electromagnetic compatibility testing. The test system (54) comprises an anechoic chamber (56) and a biconical antenna assembly (10). The biconical antenna assembly (10) has an antenna feed point (12), a first antenna structure (14) and a second antenna structure (16). The first antenna structure (14) and the second antenna structure (16) extend from the antenna feed point (12) towards opposite directions. The biconical antenna assembly (10) comprises a first additional capacitive structure (28) that is attached to the first antenna structure (14) and a second additional capacitive structure (30) that is attached to the second antenna structure (16). The anechoic chamber (56) has a floor (58). An electromagnetic layer (60) made from a material with high dielectric properties is provided between the biconical antenna assembly (10) and the floor (58). The electromagnetic layer (60) has lower electrically conducting properties in comparison to the floor (58) of the anechoic chamber (56).

## Description

The invention relates to a test system.

In the state of the art, biconical antenna assemblies are typically used in electromagnetic interference (EMI) testing such as immunity testing or emissions testing. The biconical antenna assembly corresponds to a broadband antenna assembly that comprises two roughly conical conductive objects that extend to opposite directions, but nearly touching each other via the ends facing each other. Hence, the biconical antenna assemblies are also called butterfly antenna assemblies due to their appearance. Furthermore, a two-dimensional version of the biconical antenna assembly is called bowtie antenna assembly, which is often used for short-range ultra-high frequency (UHF) television reception.

In general, the biconical antenna assemblies have dipole-like characteristics with a wider bandwidth achieved due to the specific structure, namely the roughly conical conductive objects.

The EMC standards require a frequency range between 20 and 300 MHz to be tested. For testing purposes, the biconical antenna assemblies are connected to an amplifier such that the frequency range between 30 and 300 MHz can be covered appropriately. It is known to improve the characteristics in a lower frequency range of 30 - 60 MHz by using plates that are directly connected with end faces of the respective biconical antenna assembly. Such a biconical antenna assembly is shown in WO 00/57512 A1.

However, those biconical antenna assemblies still have a bad matching at frequencies in the range of 20 to 30 MHz, resulting in a lower field strength which is disadvantageous for testing purposes. Accordingly, it is necessary to use a more powerful amplifier for testing in order to reach the required field strength in the lower frequency range of 20 to 30 MHz due to the bad matching of the biconical antenna assemblies known in the state of the art.

However, this increases the overall costs for testing, as the powerful amplifier is more expensive.

To overcome this issue, it is known to use differently shaped additional capacitive structures compared to the plates as shown in EP 4 009 442 A1. The structures shown relate to solid bodies which have an ellipsoid shape or a spherical shape. In addition, these structures are also directly attached to the end faces of the respective biconical antenna assembly.

Even though these biconical antenna assemblies already show improved characteristics in the lower frequency range of 20 to 30 MHz, there is still need for improvement.

WO 00 / 57512 A1 describes a biconical antenna that has a removable tophat plate attached to the end of each antenna structure. The tophat plate is a planar aluminum disk.

CN 204 216 207 U shows an omnidirectional ceiling-mounted antenna consisting of a vertically and a horizontally polarized antenna. The vertically polarized antenna may be a biconical antenna.

US 2009 / 219 217 A1 and EP 3 455 640 B1 each disclose a test system comprising a housing with an absorber covering the walls inside the housing in order to prevent reflections of electromagnetic waves inside.

JP 2000 261181 A describes a liquid contained in a porous material that is used as an absorber for electromagnetic waves.

In WO 2016 / 034 025 A1 a vertically polarized omni-directional antenna is shown.

KR 101 615 310 B1 shows a foldable biconical antenna for a vehicle.

CN 101 765 777 B discloses a radio anechoic box.

US 2001 / 024 121 A1 shows an electromagnetic wave absorber with an electromagnetic wave reflector made of a metal plate.

Accordingly, there is still a need for a test system with a biconical antenna assembly that can be used with amplifiers at low frequencies in order to ensure EMC testing in an appropriate manner.

The invention further provides a test system for electromagnetic compatibility testing, wherein the test system comprises an anechoic chamber and a biconical antenna assembly for electromagnetic compatibility testing. The biconical antenna assembly has an antenna feed point, a first antenna structure and a second antenna structure. The first antenna structure and the second antenna structure extend from the antenna feed point towards opposite directions. The biconical antenna assembly comprises a first additional capacitive structure that is attached to the first antenna structure and a second additional capacitive structure that is attached to the second antenna structure. The anechoic chamber has a floor. In addition, an electromagnetic layer is provided between the biconical antenna assembly and the floor, wherein the layer has lower electrically conducting properties in comparison to the floor of the anechoic chamber.

The object is also solved by means of the specific additional electromagnetic layer that is located between the biconical antenna assembly and the floor. Since the layer has lower electrically conducting properties in comparison to the floor of the anechoic chamber, it is taken advantage of the field recovery effect. In fact, the resulting field strength exhibits an unexpected variation with distance where the properties of the ground change along the propagation path, namely at the interface of the floor to the layer. The field strength for a path that crosses regions with different electrically conducting properties may first diminish along a first region with lower electrically conducting properties, but recovers quickly once it reaches a second region with higher electrically conducting properties. This is called the field recovery effect.

Generally, the electromagnetic layer must be a material with high dielectric properties. The electromagnetic layer should not be made from material which is conducting or absorbing for the desired frequencies.

Even though the below-mentioned embodiment concerns the bowl-shaped additional capacitive structures, the test system, having the electromagnetic layer with lower electrically conducting properties in comparison to the floor of the anechoic chamber, may also be used with a biconical antenna assembly having a differently shaped additional capacitive structure, e.g. an ellipsoid shape, a substantially spherical shape or a perfectly spherical shape.

Accordingly, the test system generally comprises a biconical antenna assembly for electromagnetic compatibility testing, wherein the biconical antenna assembly has an antenna feed point, a first antenna structure and a second antenna structure, wherein the first antenna structure and the second antenna structure extend from the antenna feed point towards opposite directions, wherein the biconical antenna assembly comprises additional capacitive structures that are attached to the first antenna structure and the second antenna structure, respectively.

Generally, a biconical antenna assembly for electromagnetic compatibility (EMC) testing is described. The biconical antenna assembly has an antenna feed point, a first antenna structure and a second antenna structure. The first antenna structure and the second antenna structure extend from the antenna feed point towards opposite directions. The biconical antenna assembly comprises a first additional capacitive structure that is attached to the first antenna structure and a second additional capacitive structure that is attached to the second antenna structure. Each of the additional capacitive structures is bowl-shaped.

The idea is based on the finding that the biconical antenna assembly has an improved matching compared to the biconical antenna assemblies known in the state of the art due to the additional capacitive structure that is at least partly shaped like a bowl ("bowl-shaped"), namely a full bowl or rather a portion of a (full) bowl. Hence, the respective additional capacitive structure attached to the corresponding antenna structure does not relate to a solid body, but to a volumetric body having an open structure. Actually, the respective bowl-shaped additional capacitive structure is axially symmetrically.

Particularly, the bowl-shaped additional capacitive structure has a first end that is closed and a second end that is open, wherein the first end and the second end are opposite to each other. The second end of the respective bowl-shaped additional capacitive structure is limited by a rim that surrounds the opening of the bowl-shaped additional capacitive structure, namely the open side.

The respective additional capacitive structure may has a three-dimensional geometry. Thus, the additional capacitive structure is different to a disc or rather a plate that may terminate the respective antenna structure. The disc or rather plate may connect several radiating conductors of the respective antenna structure, thereby establishing the respective antenna structure. However, the respective additional capacitive structure may be attached to the disc or rather plate in a galvanic manner, as the disc or rather plate may be associated to the most distal point of the respective antenna structure.

In general, the respective additional capacitive structure leads to an additional capacity at the point at which the additional capacitive structure is attached to the corresponding antenna structure, for instance the most distal point of the respective antenna structure from the antenna feed point.

In fact, the respective additional capacitive structure increases the active surface, e.g. at the distal point of the respective antenna structure. Due to the open structure of the bowl-shaped additional capacitive structure, the respective active surface is further increased.

The biconical antenna assembly has a better matching such that a simple amplifier can be used together with the biconical antenna assembly in order to provide the desired field strength at low frequencies, particularly in the frequency range of 20 to 30 MHz. Particularly, the field strength achieved is improved by 3 dB up to 6 dB.

Accordingly, an EMC test can be conducted while using the biconical antenna assembly according to the present disclosure together with a simple amplifier, wherein the simple amplifier may have a lower output power compared to the ones used previously, particularly when testing in the frequency range of 20 to 30 MHz. This is possible due to the improved matching of the biconical antenna assembly which is achieved by the additional capacitive structures attached to the corresponding antenna structures, e.g. located at the most distal points of the corresponding antenna structure.

The most distal point from the antenna feed point may correspond to the point of the respective antenna structure that has the largest distance to the antenna feed point. According to a certain embodiment, the most distal point of the respective antenna structure is located on a center axis of the respective antenna structure.

Generally, the antenna structures are electrically conductive.

Moreover, the respective additional capacitive structure may also be established in an electrically conductive manner, wherein the additional capacitive structure provides an additional capacity to the entire biconical antenna assembly.

Generally, the respective additional capacitive structure is additional with respect to inherent capacities (capacitances) of components of the biconical antenna assembly, e.g. the ones of the antenna structures. Hence, the additional capacitive structures provide an extra capacitance to the biconical antenna assembly.

An aspect provides that each of the additional capacitive structures has an open side, wherein the open side is facing away from the antenna feed point. Alternatively, the respective open side is facing towards the antenna feed point. Particularly, each of the additional capacitive structures encompasses the respective antenna structure at least partly. The bowl-shaped additional capacitive structures are connected to the respective antenna structure via their closed ends that provide a mounting structure. Generally, a hole, particularly with a thread, may be provided at the closed end. A connecting element, e.g. a screw, may be used to interconnect the respective bowl-shaped additional capacitive structure to the corresponding antenna structure.

The axial distance of the entire biconical antenna assembly is not increased by means of the additional capacitive structures in case that the respective open side is facing towards the antenna feed point, as the bowl-shaped portion of the additional capacitive structures encompass the respective antenna structure at least partly. In this specific embodiment, the closed end of the bowl-shaped additional capacitive structures correspond to the most distal ends with respect to the antenna feed point.

Another aspect provides that each of the additional capacitive structures is a full bowl encompassing a volume corresponding to one half of a sphere or wherein each of the additional capacitive structures is a part of a bowl that encompasses a quarter of a sphere or less, for instance 20 degrees of a full sphere. In case the additional capacitive structures each correspond to a part of a bowl that encompasses a quarter of a sphere or less, ripples at low frequencies can be avoided effectively. Moreover, resonances within the band between 20 MHz and 250 MHz can be avoided.

Generally, the additional capacitive structures may be orientated towards the radiation direction of the biconical antenna assembly, e.g. their main surfaces face towards the radiation direction. The respective main surface relates to the main part of the overall surface.

Particularly, the additional capacitive structures, corresponding to only a part of a bowl, are orientated towards the radiation direction of the biconical antenna assembly via their surfaces. In other words, the surfaces of the additional capacitive structures being a part of a bowl that encompasses a quarter of a sphere or less, for instance 20 degrees of a full sphere, are facing the radiation direction of the biconical antenna assembly.

Particularly, the respective antenna structure has an end face at which a most distal point of the respective antenna structure from the antenna feed point is located. A connecting member is located within the end face. The connecting member connects several individual radiating conductors of the respective structure. The respective additional capacitive structure is attached to the end face via at least one washer, thereby establishing a gap between the respective additional capacitive structure and the connecting member. Therefore, the respective additional capacitive structure does not contact the end face or rather the connecting member since the gap is provided which ensures an increased field strength. Particularly, an improvement of more than 3 dB in field strength is obtained by using the gap.

For instance, the gap is at least 3 mm. The 3 mm gap provides good matching characteristics and increased field strength.

Moreover, the several individual radiating conductors may have a fractal structure. Hence, the respective radiating conductors are not made of (straight) rods. Due to the fractal structure, the electrical length is increased without increasing the physical length of the biconical antenna assembly. Therefore, a compact biconical antenna assembly can be provided which has characteristics comparable to a larger biconical antenna assembly, namely with respect to the electrical length. The fractal structure of the radiating conductors provides an additional increase of 2 dB with regard to the field strength of the biconical antenna assembly.

Generally, the biconical antenna assembly is such compact that it can be used for vertically polarized signals since the biconical antenna assembly does not touch the ground while still keeping enough distance in order to avoid any arcing.

According to a further aspect, a ferromagnetic material, for instance a magneto-dielectric material, is provided at a base of the biconical antenna assembly, in particular wherein the ferromagnetic material is provided by a coating. The ferromagnetic material also optimizes the matching characteristics of the biconical antenna assembly.

Another aspect provides that the biconical antenna assembly comprises a balun with at least one ring-shaped core embedded into a heat sink body. Particularly, the biconical antenna assembly comprises a balun with several ring-shaped core bands axially distanced from each other, but embedded into a common heat sink body. Hence, a cooling system is provided that is configured to cool the balun during operation. The balun is an electrical device that converts between a balanced signal and an unbalanced signal, or feed line without disturbing the impedance arrangement. Baluns, particularly radio frequency (RF) baluns, are typically used with antennas and their antenna feed points to transform a balanced feed or line to an unbalanced one. The additional cooling associated with the balun, namely the heat sink body, is used for cooling the balun, thereby increasing the operational range of the balun with regard to high powers, e.g. in the range of 2 to 15 kW, particularly between 5 and 10 kW, instead of typical baluns only usable up to 1 kW.

An aspect provides that the biconical antenna assembly is placed on the layer. Hence, the layer lays on the floor wherein the biconical antenna assembly is placed on the layer that is lying on the floor. Accordingly, the layer may be a mat that is placed on the floor of the anechoic chamber.

Moreover, the layer is distanced to the floor. The biconical antenna assembly may still be placed on the layer which however is not placed on the floor, but distanced thereto. Alternatively, the biconical antenna assembly is placed on the floor via its stand whereas the layer is distanced to the floor. Thus, the distance between the layer and the feed point of the biconical antenna assembly is shorter than the distance between the floor and the feed point of the biconical antenna assembly.

The floor may be a conducting grounded floor such that the floor has improved electrically conducting characteristics compared to the layer. This increases the recovery effect.

For instance, the layer comprises an electrostatic discharge mat or a water layer, particularly a salt water layer. The water layer may be provided by a container filled with water, e.g. salt water. The water layer may be placed on the floor directly or placed on a stand that is located on the floor. The lay may be a graphene covert mat which can be placed underneath the biconical antenna assembly.

The biconical antenna assembly may comprise a stand, particularly a movable stand. Accordingly, the biconical antenna assembly is movable. Furthermore, the layer may be part of the movable stand such that the layer is simultaneously moved when the biconical antenna assembly is moved via the movable stand.

Another aspect provides that the test system comprises a test location for a device under test, which is located in the anechoic chamber. The layer extends until 1 m in front of the test location, particularly up to the test location. This respective setup ensures best characteristics with regard to the recovery effect when testing the device under test located at the test location. As indicated above, the field recovery effect will be responsible for the higher field strength at the device under test. This effect can help with any antenna above the dielectric layer

According to a further aspect, the anechoic chamber has side walls as well as a ceiling wall. An absorber is provided at an inner surface inner surface of the ceiling wall and/or the side walls, in particular wherein the absorber is made from an electrically conducting foam with Ferrite particles. The absorber

For instance, the first antenna structure and the second antenna structure each have a substantially conical geometry. Particularly, the first antenna structure and the second antenna structure each have a first conical portion and a second conical portion, which are connected with each other via their wide ends. The respective antenna structures ensure that the entire biconical antenna assembly has its biconical shape, particularly each of the antenna structures itself is biconically shaped due to the first and second conical portions.

The biconical antenna assembly may be foldable, particularly the first and/or second antenna structure. For this functionality, the respective conical portions of the respective antenna structures can be folded accordingly. Thus, the entire biconical antenna assembly can be folded in order to obtain a compact size for transporting.

In general, the biconical antenna assembly has improved characteristics in the frequency range of 20 to 30 MHz. This results in an improved field strength and an improved efficiency.

For instance, the biconical antenna assembly comprises a first additional capacitive structure and a second additional capacitive structure. The first additional capacitive structure is attached to the first antenna structure, particularly a most distal point of the first antenna structure from the antenna feed point. The second additional capacitive structure is attached to the second antenna structure, particularly a most distal point of the second antenna structure from the antenna feed point. Therefore, two additional capacitive structures are provided that are located at the respective antenna structures, particularly the most distal ends of the biconical antenna assembly.

The additional capacitive structures may be shaped and/or configured in a similar manner such that the biconical antenna assembly is adapted in a symmetric manner concerning its capacitive properties.

Generally, the antenna structures each may have a respective center axis, wherein their center axes coincidence with each other. The respective additional capacitive structures each may have a center that is located on the center axes that also run through the center of the antenna feed point.

Furthermore, the most distal point of the respective antenna structure may also be located on its respective center axis.

Particularly, the biconical antenna assembly is symmetrically shaped, wherein the antenna feed point is located in the center of symmetry. The entire biconical antenna assembly has a symmetric geometry. The symmetry of the biconical antenna assembly may be established by the additional capacitive structures that are located at the respective antenna structures to which the additional capacitive structures are attached.

Another aspect provides that the additional capacitive structures provide improved matching characteristics of the biconical antenna assembly. The additional capacity provided by the additional capacitive structure adapts the matching characteristics of the biconical antenna assembly. Accordingly, the biconical antenna assembly may be connected with an amplifier that can be operated at lower output power compared to the ones used in the state of the art in order to achieve the desired field strength at low frequencies, namely in the frequency range between 20 MHz and 30 MHz.

Further, the antenna structures nearly touch each other at their ends facing the antenna feed point, e.g. distanced by a gap. Put differently, the antenna structures nearly touch each other at those ends that are not assigned to the additional capacitive structure since the additional capacitive structures are attached to the most distal points of the respective antenna structure from the antenna feed point. The antenna structure ends facing each other correspond to those that are located next to the antenna feed point.

The foregoing aspects and many of the attendant advantages of the claimed subject matter will become more readily appreciated as the same become better understood by reference to the following detailed description, when taken in conjunction with the accompanying drawings, wherein:
- Figure 1 schematically shows a biconical antenna assembly according to a first example;
- Figure 2 schematically shows the biconical antenna assembly of Figure 1 in a different view;
- Figure 3 schematically shows a biconical antenna assembly according to a second example;
- Figure 4 schematically shows a biconical antenna assembly according to a third example;
- Figure 5 schematically shows a biconical antenna assembly according to a fourth example;
- Figure 6 schematically shows a biconical antenna assembly according to a further example,
- Figure 7 schematically shows a balun assembly to be incorporated into a biconical antenna assembly according to an example of the present disclosure,
- Figure 8 shows a sectional view of the balun assembly of Figure 7,
- Figure 9 shows another sectional view of the balun assembly of Figures 7 and 8,
- Figure 10 shows a detail of the connection of one additional capacitive structure to a corresponding antenna structure of a biconical antenna assembly according to an example of the present disclosure,
- Figure 11 shows another detail of the connection of one additional capacitive structure to a corresponding antenna structure of a biconical antenna assembly according to an example of the present disclosure,
- Figure 12 shows a test system according to an embodiment of the present invention, and
- Figure 13 shows a test system according to another embodiment of the present invention.

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the claimed subject matter to the precise forms disclosed.

For the purposes of the present disclosure, the phrase "at least one of A, B, and C", for example, means (A), (B), (C), (A and B), (A and C), (B and C), or (A, B, and C), including all further possible permutations when more than three elements are listed. In other words, the term "at least one of A and B" generally means "A and/or B", namely "A" alone, "B" alone or "A and B".

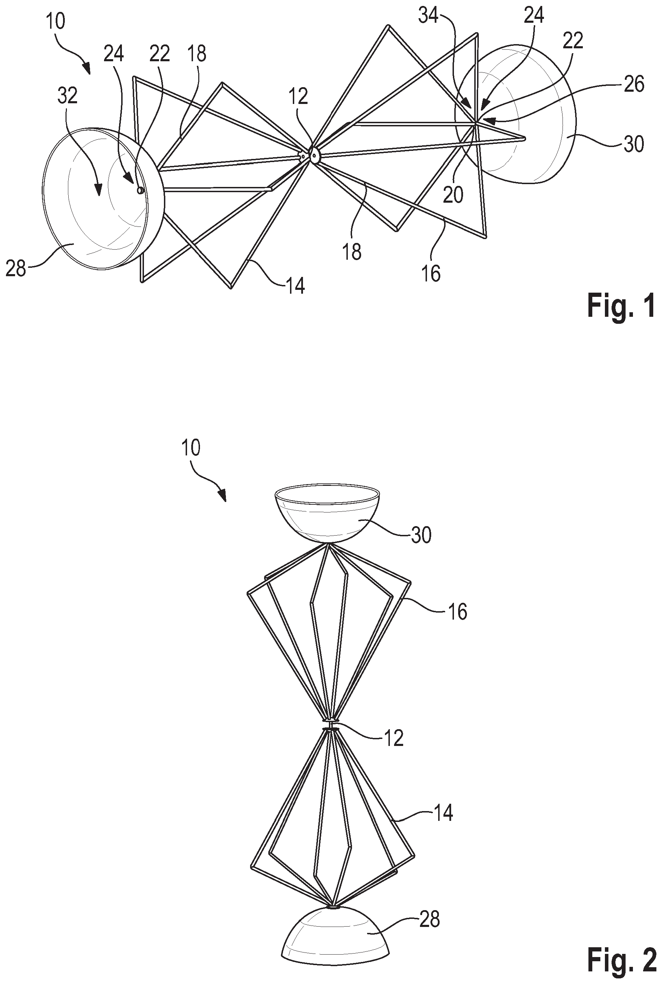

Figures 1 and 2 show a first embodiment of a biconical antenna assembly 10 according to the present disclosure, which is used for electromagnetic compatibility testing (EMC testing).

The biconical antenna assembly 10 has an antenna feed point 12 as well as a first antenna structure 14 and a second antenna structure 16 that extend from the antenna feed point 12 towards opposite directions.

The antenna structures 14, 16 each comprise several individual radiating conductors 18 that are connected via their ends 20 facing away from the antenna feed point 12 to a connecting member 22. The respective connecting member 22 is located within an end face 24 of the respective antenna structures 14, 16 at which a most distal point 26 of the respective antenna structures 14, 16 is located.

As shown in Figures 1 and 2, the biconical antenna assembly 10 is symmetrically shaped, wherein the antenna feed point 12 is located in the center of symmetry. The entire biconical antenna assembly 10 has a symmetric geometry, e.g. the respective antenna structures 14, 16.

Moreover, the biconical antenna assembly 10 comprises a first additional capacitive structure 28 that is attached to the first antenna structure 14 and a second additional capacitive structure 30 that is attached to the second antenna structure 16. Each of the additional capacitive structures 28, 30 is bowl-shaped.

In the embodiment shown in Figures 1 and 2, the additional capacitive structures 28, 30 are full bowls that encompass a volume corresponding to one half of a sphere. The full bowls have an open side 32 that is facing away from the antenna feed point 12. The additional capacitive structures 28, 30 established by the full bowls are connected to the respective antenna structures 14, 16 via their closed ends 34 that are opposite to the open sides 32.

In fact, the close ends 34 provide a mounting structure 36, for instance a hole, particularly with a thread. A connecting element 38, e.g. a screw, a rod or a bolt, may be used to interconnect the respective bowl-shaped additional capacitive structure 28, 30 to the corresponding antenna structure 14, 16.

The additional capacitive structures 28, 30 are connected via their closed ends 34 to the end faces 24 of the respective antenna structures 14, 16 via at least one washer 40, e.g. several washers 40 arranged in series. The at least one washer 40 establishes a gap 42 between the respective additional capacitive structure 28, 30 and the corresponding connecting member 22 located at the respective end face 24. Particularly, the gap 42 is at least 3 mm.

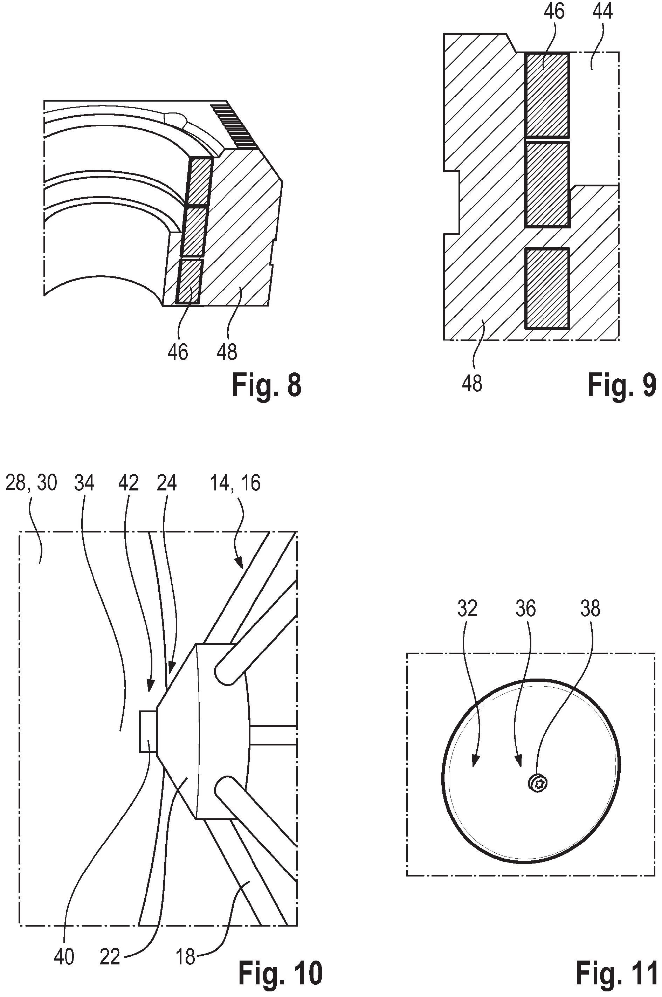

These details are shown in Figures 10 and 11.

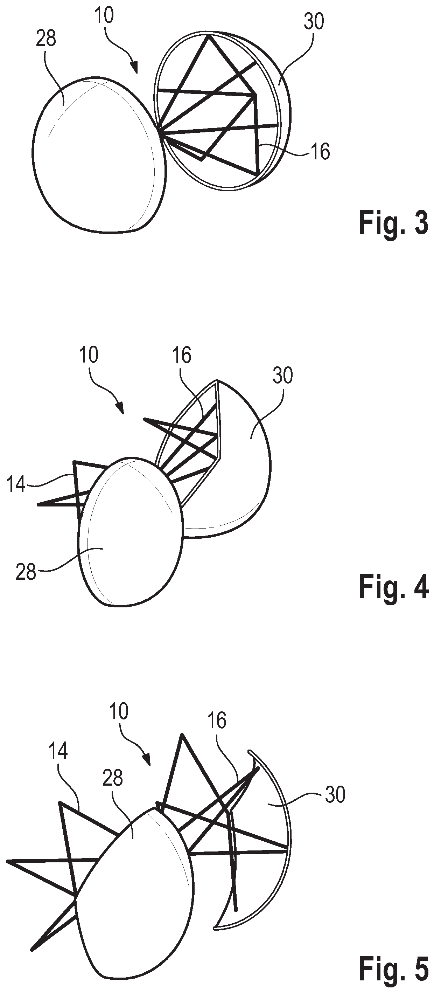

In Figure 3, another embodiment is shown according to which the additional capacitive structures 28, 30 are flipped by 180° such that the additional capacitive structures 28, 30 do not elongate the (axial) distance of the biconical antenna assembly 10.

In fact, the open sides 32 of the additional capacitive structures 28, 30, which are still established by full bowls, are facing towards the respective antenna feed point 12. Hence, each of the additional capacitive structures 28, 30 encompasses the respective antenna structure 14, 16 partly. The closed ends 34 of the bowl-shaped additional capacitive structures 28, 30 correspond to the most distal points of the entire biconical antenna assembly 10. The bowl-shaped additional capacitive structures 28, 30 are connected to the antenna structures 14, 16 via the closed ends 34, particularly in a similar manner as described with respect to the embodiment according to Figures 1 and 2.

Generally, the bowl-shaped additional capacitive structures 28, 30 established by full bowls each encompass a volume corresponding to one half of a sphere

In Figure 4, a further embodiment is shown in which the bowl-shaped additional capacitive structures 28, 30 only relate to a part of a bowl that encompasses a quarter of a sphere. Hence, the bowl-shaped additional capacitive structures 28, 30 are halved with respect to the bowl-shaped additional capacitive structures 28, 30 shown in the previous embodiments. Nevertheless, the additional capacitive structures 28, 30 are still bowl-shaped due to their respective shapes being part of a full bowl.

The additional capacitive structures 28, 30 may face towards the radiation direction of the biconical antenna assembly 10, particularly by means of their main surfaces. In other words, the additional capacitive structures 28, 30 each only corresponding to a part of a bowl are mounted to the respective antenna structures 14, 16 such that they both are orientated towards the radiation direction of the biconical antenna assembly 10.

In Figure 5, another embodiment is shown in which the bowl-shaped additional capacitive structures 28, 30 only relate to a part of a bowl that encompasses less than a quarter of a sphere, e.g. a cut-out of 20° of the entire bowl, namely the full bowl. However, the additional capacitive structures 28, 30 are still shaped like a part of a bowl, e.g. they have a shape like a part of a bowl. Therefore, these additional capacitive structures 28, 30 are also bowl-shaped.

As discussed above, the additional capacitive structures 28, 30 also face towards the radiation direction of the biconical antenna assembly 10, particularly by means of their main surfaces.

Generally, both additional capacitive structures 28, 30 are located on the side of the biconical antenna assembly 10 that is facing the radiation direction of the biconical antenna assembly 10.

Irrespective of the specific design of the bowl-shaped additional capacitive structures 28, 30, they may be attached to the corresponding antenna structures 14, 16 in the same way as described above with regard to the first embodiment.

Therefore, the different embodiments have in common that the biconical antenna assembly 10 has the antenna feed point 12, the first antenna structure 14 and the second antenna structure 16. The first antenna structure 14 and the second antenna structure 16 extend from the antenna feed point 12 towards opposite directions. The biconical antenna assembly 10 comprises a first additional capacitive structure28 that is attached to the first antenna structure 14 and a second additional capacitive structure 30 that is attached to the second antenna structure 16. Each of the additional capacitive structures 28, 30 is bowl-shaped.

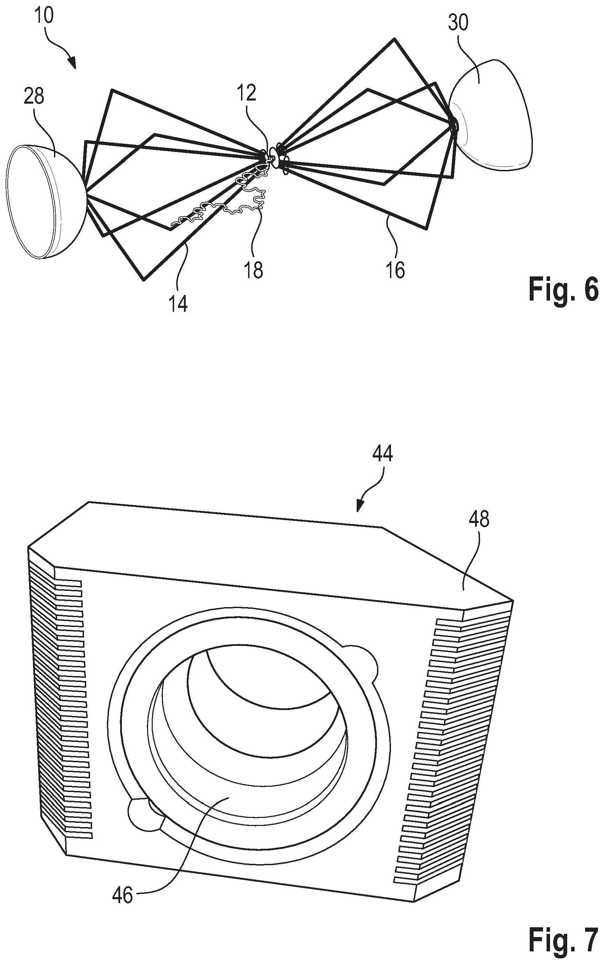

In a specific embodiment shown in Figure 6, the several individual radiating conductors 18 may have a fractal structure.

Accordingly, the electrical length of the biconical antenna assembly 10 is increased without increasing the physical length/width of the biconical antenna assembly 10. Therefore, a compact biconical antenna assembly 10 is provided that has improved characteristics.

In the shown embodiment, the additional capacitive structures 28, 30 are established like the ones of the first embodiment. However, the additional capacitive structures 28, 30 may also be shaped like the ones shown in the second, third or fourth embodiment.

In Figures 7 to 9, a specific arrangement of the biconical antenna assembly 10 is shown, as the biconical antenna assembly 10 may also comprise a balun assembly having a balun 44 with at least one ring-shaped core 46 embedded into a heat sink body 48. The at least one ring-shaped core 46 may also be called ring-shaped core band.

As shown in the respective Figures 7 to 9, particularly Figures 8 and 9, the balun 44 has several ring-shaped core bands, e.g. three ring-shaped core bands, that are axially distanced from each other, but embedded into the common heat sink body 48.

Accordingly, a cooling system is provided that is configured to cool the balun 44 during operation of the biconical antenna assembly 10. The additional cooling associated with the balun 44, namely the heat sink body 48, is used for cooling the balun 44, thereby increasing the operational range of the balun 44 with regard to high powers, e.g. in the range of 2 to 15 kW, particularly between 5 and 10 kW, instead of typical baluns only usable up to 1 kW.

Particularly, no windings are provided about the balun 44 comprising the several ring-shaped core bands that are axially distanced from each other, but embedded into the common heat sink body 48. The heat sink body 48 conveys away any heat generated within the balun 44 during operation, particularly within the several ring-shaped core bands, for instance the ring-shaped core band located next to a load connected to the biconical antenna assembly 10.

Moreover, a ferromagnetic material, for instance a magneto-dielectric material, is provided at a base of the biconical antenna assembly 10. The ferromagnetic material may be provided by a coating.

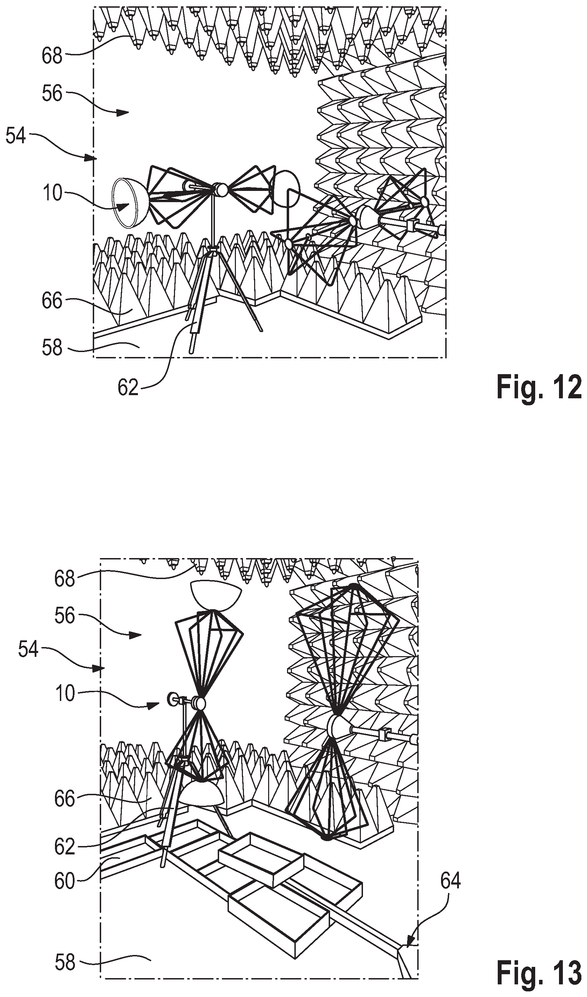

In Figures 12 and 13, a test system 54 for electromagnetic compatibility (EMC) testing is shown.

The test system 54 comprises an anechoic chamber 56 and a biconical antenna assembly 10, particularly one of the above-mentioned ones.

However, the design of the additional capacitive structures 28, 30 may be different, e.g. the additional capacitive structures 28, 30 may have an ellipsoid shape, a substantially spherical shape or a perfectly spherical shape.

The anechoic chamber 56 has a floor 58, wherein an electromagnetic layer 60 is provided between the biconical antenna assembly 10 and the floor 58 as shown in Figure 13.

The layer 60 has lower electrically conducting properties in comparison to the floor 58 of the anechoic chamber 56.

The layer 60 comprises an electrostatic discharge mat or a water layer, particularly a salt water layer.

Generally, the biconical antenna assembly 10 may be placed on the layer 60.

The layer 60 may be placed on the floor 58, e.g. like a mat that is put on the floor 58.

However, the layer 60 may also be distanced to the floor 58 such that a gap is provided between the layer 60 and the floor 58.

The biconical antenna assembly 10 may comprise a stand 62, particularly a movable stand.

The layer 60 may be part of the stand 62 such that the layer 60 can be moved together with the biconical antenna assembly 10, thereby ensuring that a relative orientation between the biconical antenna assembly 10 and the layer 60 is maintained. In this embodiment, the layer 60 may be distanced to the floor 58.

Generally, the test system 54 comprises a test location 64 for a device under test, which is located in the anechoic chamber 56, wherein the layer 60 extends until 1 m in front of the test location 64, particularly up to the test location 64.

The anechoic chamber 56 has side walls as well as a ceiling wall, wherein an absorber 66 is provided at an inner surface inner surface of the ceiling wall and/or the side walls. Particularly, the absorber 66 is made from an electrically conducting foam with Ferrite particles 68, e.g. at the tips of absorbing elements formed by the absorber, for instance pyramids or similar structures.

Generally, the additional capacitive structures 28, 30, provide improved matching characteristics of the biconical antenna assembly 10. The additional capacity provided by the additional capacitive structures 28, 30 adapts the matching characteristics of the biconical antenna assembly 10. Accordingly, the biconical antenna assembly 10 is enabled to achieve the desired field strength at low frequencies, namely in the frequency range between 20 MHz and 30 MHz.

Certain embodiments disclosed herein, particularly the respective module(s) and/or unit(s), utilize circuitry (e.g., one or more circuits) in order to implement standards, protocols, methodologies or technologies disclosed herein, operably couple two or more components, generate information, process information, analyze information, generate signals, encode/decode signals, convert signals, transmit and/or receive signals, control other devices, etc. Circuitry of any type can be used.

In an embodiment, circuitry includes, among other things, one or more computing devices such as a processor (e.g., a microprocessor), a central processing unit (CPU), a digital signal processor (DSP), an application-specific integrated circuit (ASIC), a field-programmable gate array (FPGA), a system on a chip (SoC), or the like, or any combinations thereof, and can include discrete digital or analog circuit elements or electronics, or combinations thereof. In an embodiment, circuitry includes hardware circuit implementations (e.g., implementations in analog circuitry, implementations in digital circuitry, and the like, and combinations thereof).

In an embodiment, circuitry includes combinations of circuits and computer program products having software or firmware instructions stored on one or more computer readable memories that work together to cause a device to perform one or more protocols, methodologies or technologies described herein. In an embodiment, circuitry includes circuits, such as, for example, microprocessors or portions of microprocessor, that require software, firmware, and the like for operation. In an embodiment, circuitry includes one or more processors or portions thereof and accompanying software, firmware, hardware, and the like.

The present application may reference quantities and numbers. Unless specifically stated, such quantities and numbers are not to be considered restrictive, but exemplary of the possible quantities or numbers associated with the present application. Also in this regard, the present application may use the term "plurality" to reference a quantity or number. In this regard, the term "plurality" is meant to be any number that is more than one, for example, two, three, four, five, etc. The terms "about", "approximately", "near" etc., mean plus or minus 5% of the stated value.

## Claims

1. A test system (54) for electromagnetic compatibility testing, wherein the test system (54) comprises an anechoic chamber (56) and a biconical antenna assembly (10) for electromagnetic compatibility testing, wherein the biconical antenna assembly (10) has an antenna feed point (12), a first antenna structure (14) and a second antenna structure (16), wherein the first antenna structure (14) and the second antenna structure (16) extend from the antenna feed point (12) towards opposite directions, wherein the biconical antenna assembly (10) comprises a first additional capacitive structure (28) that is attached to the first antenna structure (14) and a second additional capacitive structure (30) that is attached to the second antenna structure (16), wherein the anechoic chamber (56) has a floor (58), **characterized in that** an electromagnetic layer (60) made from a material with high dielectric properties is provided between the biconical antenna assembly (10) and the floor (58), wherein the electromagnetic layer (60) has lower electrically conducting properties in comparison to the floor (58) of the anechoic chamber (56).

2. The test system according to claim 1, wherein the biconical antenna assembly (10) is placed on the electromagnetic layer (60) and/or wherein the layer (60) is distanced to the floor.

3. The test system according to claim 1 or 2, wherein the floor (58) is a conducting grounded floor.

4. The test system according to any one of the preceding claims, wherein the electromagnetic layer (60) comprises an electrostatic discharge mat or a water layer, particularly a salt water layer.

5. The test system according to any one of the preceding claims, wherein the biconical antenna assembly (10) comprises a stand (62), particularly a movable stand, and wherein the electromagnetic layer (60) is part of the stand (62).

6. The test system according to any one of the preceding claims, wherein the test system comprises a test location (64) for a device under test, which is located in the anechoic chamber (56), and wherein the electromagnetic layer (60) extends until 1 m in front of the test location (64), particularly up to the test location (64).

7. The test system according to any one of the preceding claims, wherein the anechoic chamber (56) has side walls as well as a ceiling wall, wherein an absorber (66) is provided at an inner surface inner surface of the ceiling wall and/or the side walls, in particular wherein the absorber is made from an electrically conducting foam with Ferrite particles (68).

8. The test system according to any one of the preceding claims, wherein each of the additional capacitive structures (28, 30) is bowl-shaped.

9. The test system according to any one of the preceding claims, wherein each of the additional capacitive structures (28, 30) has an open side, and wherein the open side is facing away from the antenna feed point (12) or towards the respective antenna feed point (12), particularly wherein each of the additional capacitive structures (28, 30) encompasses the respective antenna structure (14, 16) partly.

10. The test system according to any one of the preceding claims, wherein each of the additional capacitive structures (28, 30) is a full bowl encompassing a volume corresponding to one half of a sphere or wherein each of the additional capacitive structures (28, 30) is a part of a bowl that encompasses a quarter of a sphere or less.

11. The test system according to any one of the preceding claims, wherein the respective antenna structure has an end face (24) at which a most distal point of the respective antenna structure from the antenna feed point (12) is located, wherein a connecting member (22) is located within the end face (24), and wherein the connecting member (22) connects several individual radiating conductors (18) of the respective structure, wherein the respective additional capacitive structure (28, 30) is attached to the end face (24) via at least one washer (40), thereby establishing a gap (42) between the respective additional capacitive structure (28, 30) and the connecting member (22).

12. The test system according to claim 11, wherein the gap (42) is at least 3 mm.

13. The test system according to claim 11 or 12, wherein the several individual radiating conductors (18) have a fractal structure.

14. The test system according to any one of the preceding claims, wherein a ferromagnetic material, for instance a magneto-dielectric material, is provided at a base of the biconical antenna assembly (10), in particular wherein the ferromagnetic material is provided by a coating.

15. The test system according to any one of the preceding claims, wherein the biconical antenna assembly (10) comprises a balun (44) with at least one ring-shaped core (46) embedded into a heat sink body (48), particularly a balun (44) with several ring-shaped core bands axially distanced from each other, but embedded into a common heat sink body (48).
